Europäisches Patentamt

European Patent Office

Office européen des brevets

(19)

(11) Publication number: **0 084 252**
**B1**

(12) **EUROPEAN PATENT SPECIFICATION**

(45) Date of publication of patent specification: 16.07.86

(51) Int. Cl.⁴: **G 11 C 11/40**

(21) Application number: **82306888.7**

(22) Date of filing: **23.12.82**

(54) Semiconductor memory device.

(30) Priority: **29.12.81 JP 213411/81**

(43) Date of publication of application:
**27.07.83 Bulletin 83/30**

(45) Publication of the grant of the patent:
**16.07.86 Bulletin 86/29**

(84) Designated Contracting States:
**DE FR GB**

(56) References cited:
**US-A-4 057 789**

**PATENT ABSTRACTS OF JAPAN, vol. 6, no.
46(P107)(924), 24th March 1982**

**IEEE JOURNAL OF SOLID-STATE CIRCUITS,
vol. SC-9, no. 5, October 1974, pages 283-284,
New York, USA, H. MAYUMI et al.: "A 25-ns
read access bipolar 1 kbit TTL RAM"**

(73) Proprietor: **FUJITSU LIMITED
1015, Kamikodanaka Nakahara-ku
Kawasaki-shi Kanagawa 211 (JP)**

(72) Inventor: **Sato, Masashi
1812-10 Shimonumabe, Nakahara-ku
Kawasaki-shi Kanagawa 211 (JP)**
Inventor: **Sugo, Yasuhisa
3-25-13, Minamikoiwa
Edogawa-ku Tokyo 133 (JP)**

(74) Representative: **Fane, Christopher Robin King
et al
HASELTINE LAKE & CO. Hazlitt House
28 Southampton Buildings, Chancery Lane
London, WC2A 1AT (GB)**

## Description

The present invention relates to a semiconductor memory device, more particularly to a semiconductor memory device comprised of static type memory cells each including, as a load, two parallel circuits each comprised of both a Schottky barrier diode (SBD) and resistor.

A static type memory cell is usually comprised of a pair of transistors formed as a flip-flop and of loads connected to these transistors. The memory cell is driven by a word line and a bit line. The word line is driven by a socalled word decoder driver and the bit line is driven by a bit current supplying circuit (explained in detail hereinafter).

The loads to be connected to the transistors usually comprise a resistor. In recent years, however, loads have often been constructed in a form of SBD's and resistors in parallel circuits. Such loads have the advantage of enabling a high degree of speed in the read/write operation in the memory. The reason for this is well known.

In the prior art, however, static type memory cells containing SBD's, suffer from problems arising from the variation in forward voltage $V_F$ of the SBD's due to the manufacturing process, i.e., arising from the inability to maintain $V_F$ strictly at a predetermined value. The first problem is that a large write margin is required to prevent erroneous write operation. The second is that insufficient write current must be compensated.

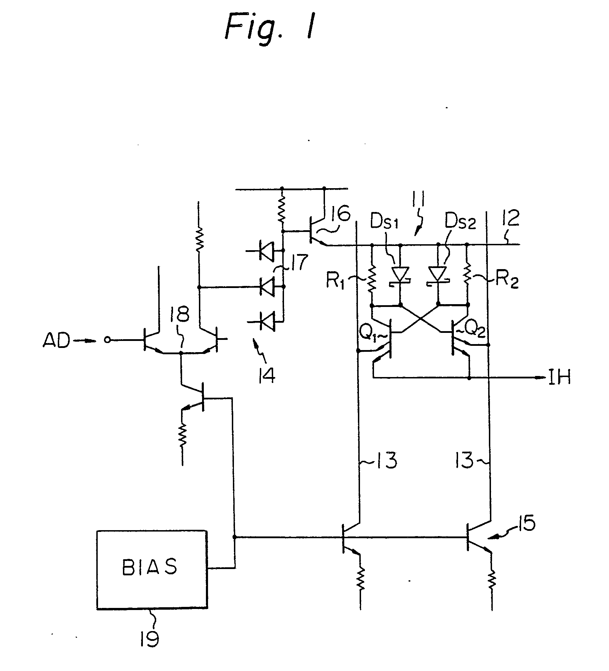

A prior art semiconductor memory device having the features of the pre-characterising part of claim 1 is disclosed herein and shown in Fig. 1.

Attention is directed also to IEEE Journal of Solid State Circuits, Vol. SC-9, No. 5, October 1974, pages 283—284, where, in an article by MAYUMI et al, a semiconductor memory device not employing Schottky barrier diodes is disclosed.

Japanese patent application 56-159894 discloses a memory device having memory cells which include load diodes (which are not disclosed to be Schottky barrier diodes). A circuit for controlling read and write incorporates reference voltage generating circuits comprising diodes of the same form as load diodes of a memory cell disposed on both sides of the memory cell. If diode characteristics of the load diodes fluctuate, the characteristics of the diodes in the reference voltage generating circuits vary in a similar manner.

U.S. Patent No. 4 057 789 discloses a memory device in which memory cells comprise loads in the form of a Schottky barrier diode and a resistor in parallel. A sense amplifier of the device employs a reference voltage source and a "simulated memory cell". The "simulated memory cell" incorporates a Schottky barrier diode, and is provided for simulating the loading of a number of memory cells as seen by a word driver. The currents flowing in the reference voltage source simulate currents flowing in the memory cells, so that when potentials in the memory cells change with temperature, potentials in the bias circuit change in a related manner. The output potential of the reference voltage source is thus maintained at a mid value of the voltage swing of the memory cells.

According to the present invention there is provided a semiconductor memory device comprising:
a plurality of word lines;
a plurality of bit lines;
static type memory cells connected to the word lines and the bit lines and having as their loads, parallel circuits comprising each a first Schottky barrier diode and a resistor;
word decoder driver circuits, comprising
word line driving means connected to the word lines, operable to determine word line voltage, and
first constant-current circuitry connected to the word line driving means and operable to generate current in dependence upon which such means are operable to determine word line voltage,
second constant-current circuitry operable to generate bit line current, and
a bias circuit for supplying a bias voltage to said first and second constant-current circuitry in common for controlling current generated by the first and second constant-current circuitry;
characterised in that
said bias circuit comprises a second Schottky barrier diode, having a forward voltage substantially the same as that of said first Schottky barrier diodes and in dependence upon which said bias voltage is determined, whereby word line voltage and bit line current are determined in dependence upon the forward voltage, so that effects of variation of the forward voltage of said first Schottky barrier diodes upon operations of said memory cells are compensated.

An embodiment of the present invention can provide a semiconductor memory device in which a bias circuit works not only to achieve its inherent biasing operation, but also to easily suppress the effect of variation of $V_F$ to substantially zero, thereby eliminating the above two problems of the prior art.

In an embodiment of the present invention, a bias circuit incorporates an SBD identical to SBD's comprised in the memory cell, in consideration of the experimentally proved fact that all SBD's produced from the same production lot have substantially the same value of $V_F$. Consequently, when the $V_F$ of the SBD is large, it will increase the current flowing through a first constantcurrent circuit, (mentioned later), thereby decreasing the "low level" of the word line, and, simultaneously, increase the current flowing through a second constantcurrent circuit, (mentioned later).

Reference is made, by way of example, to the accompanying drawings, wherein:
Fig. 1 is a circuit diagram of a prior art semiconductor memory device;
Fig. 2 is a circuit diagram of a semiconductor memory device according to a first embodiment of the present invention;
Fig. 3 is a circuit diagram of a semiconductor memory device according to a second embodiment of the present invention; and

Fig. 4 is a circuit diagram of a semiconductor memory device according to a third embodiment of the present invention.

Figure 1 is a circuit diagram of a prior art semiconductor memory device. In Fig. 1, reference numeral 11 represents one of the static type memory cells; in actuality, many identical memory cells (not shown) are arranged in both the X and Y directions. The memory cell 11 is connected to both word line 12 and bit lines, i.e. bit line pair, 13. In actuality, many identical word and bit lines (not shown) are distributed on a substrate.

The word line 12 is connected to a word decoder driver 14 provided with a first constant-current circuit 18. Reference numeral 16 represents a word driver. Reference numeral 17 represents a group of diodes which cooperate with the first constant-current circuit 18 so as to construct a word decoder of the diode-matrix type. Reference symbol AD denotes an address.

The bit lines 13 are connected to a second constantcurrent circuit 15 so as to produce bit currents flowing through the bit-lines. The second constant-current circuit 15 is connected to a bias circuit 19 together with the first constant-current circuit 18. (Alternatively, the circuit 15 may be connected independently from the circuit 18). This bias circuit 19 functions to maintain the constant currents flowing through the circuits 15 and 18 at predetermined values.

The present invention, as previously mentioned, particularly refers to a static type memory cell including an SBD therein. In the circuit of Fig. 1, the loads, to be connected to transistors $Q_1$ and $Q_2$ comprising the memory cell 11 in a form of a flip-flop, are constructed as a first parallel circuit of an SBD $D_{s1}$ and a resistor $R_1$ and a second parallel circuit of an SBD $D_{s2}$ and a resistor $R_2$, respectively. In this circuit, a hold current IH is absorbed from the memory cell via the transistors $Q_1$ and $Q_2$. The merit of utilizing the SBD's resides in, as previously mentioned, achieving high speed read/write operation of the memory.

The SBD, however, is not advantageous from the viewpoint of the forward voltage $V_F$. That is, as previously mentioned, the voltage $V_F$ is not constant but varies due to the manufacturing process. The variation of the $V_F$ defined by the SBD's $D_{s1}$ and $D_{s2}$ causes variation in the "low" level of a nonselected word line. If the memory cell 11 is connected to the currently nonselected word line the variation of the $V_F$ will swing the "low" level of the word line 12, determined by the emitter voltage of the word driver 16, upward or downward. Such variation of the word line voltage will often produce erroneous write operations. Therefore, a large write margin must usually be taken into consideration during the write operation to substantially absorb such variation.

Further, a large $V_F$ may sometimes causes a write current to be divided (diverted) into the transistor $Q_1$ or $Q_2$ which is off during the write operation. Such division of the write current into an off transistor will lead to insufficient write current for achieving the optimal write operation. Therefore, it is necessary to compensate for such insufficiency of the write current due to division of the write current.

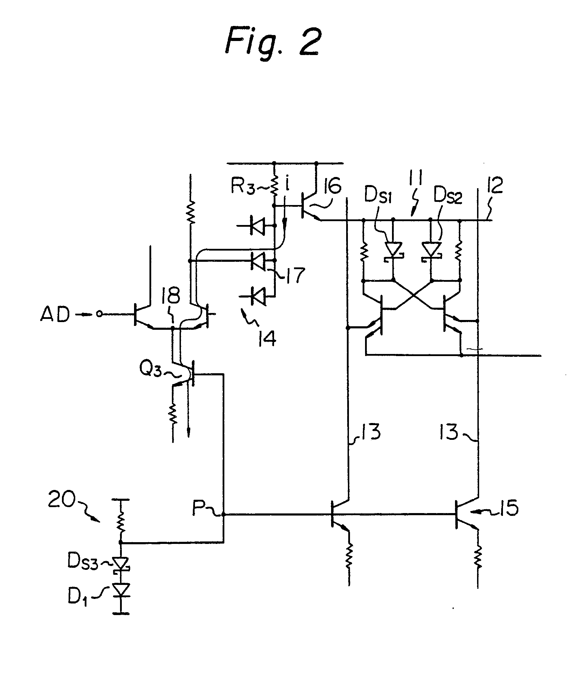

Figure 2 is a circuit diagram of semiconductor memory device according to a first embodiment of the present invention. In Fig. 2, members the same as those of Fig. 1 are represented by the same reference numerals or symbols. (Same for later Figures). In Fig. 2, reference numeral 20 represents a bias circuit, in the bias circuit 20, an SBD $D_{s3}$ is incorporated. The $V_F$ characteristic of the SBD $D_{s3}$ is substantially the same as the $V_F$ characteristics of the SBD's $D_{s1}$ and $D_{s2}$, because these SBD's are all in the same semiconductor chip.

Assuming that SBD's $D_{s1}$ and $D_{s2}$ are manufactured with large $V_F$'s, SBD $D_{s3}$ will also have a large $V_F$. Accordingly, the voltage level at the point P in Fig. 2 will also be increased by the SBD $D_{s3}$ along with the increase of the $V_F$ thereof. The relatively high voltage level at the point P is, on one hand, transmitted to the first constant-current circuit 18 by way of a transistor $Q_3$. Thus, the transistor $Q_3$ is made highly conductive and, thereby, the constant current flowing through the circuit 18 is changed to a relatively high level. This means an excessive current i flows along the arrow shown in Fig. 2. At the same time, the voltage drop across a resistor $R_3$ increases due to the current i flowing therethrough, reducing the voltage level of the word line 12. As a result, the effect of large $V_F$ of the SBD's $D_{s1}$ and $D_{s2}$ can be substantially suppressed. In a similar way, the effect of a small $V_F$ can be suppressed.

On the other hand, the relatively high voltage level at the point P influences the second constant-current circuit 15, changing the constant-current flowing therethrough to a relatively high level. This changed high constant-current can compensate for the aforementioned insufficiency of the write current. Consequently, the effect of variation of the $V_F$ in each semiconductor memory device can be substantially compensated for by each lot. Further, in Fig. 2, a diode $D_1$ in the bias circuit 20 functions for balancing with the base-emitter voltage of each transistor comprising the second constantcurrent circuit 15. Accordingly, the diode $D_1$ is not that essential a member in the present invention.

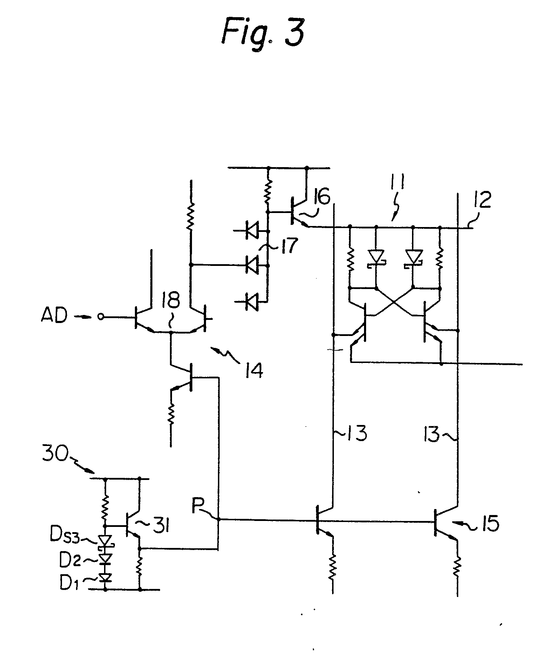

Figure 3 is a circuit diagram of a semiconductor memory device according to a second embodiment of the present invention. The principle of a bias circuit 30 in the second embodiment is similar to that of the bias circuit 20 in the first embodiment. The second embodiment, however, is more advantageous than the first from the following viewpoint. In the first embodiment, if a load at the point P, viewed from the SBD $D_{s3}$, becomes relatively large, a relatively large current flows through the bias circuit 20. Therefore, it is difficult to correctly vary the voltage level at the point P with just variation of $V_F$ defined by $D_{s3}$.

Contrary to the above, in the second embodiment, an emitter follower 31 is employed in the bias circuit 30. The emitter follower 31 cooperates with the SBD $D_{s3}$, and, thus, stable control of the voltage level at the point P can be performed regardless of the amount of the load at $P_1$ viewed from the SBD $D_{s3}$. In Fig. 3, the function of the diode $D_1$ and also a diode $D_2$ is the same as that of the diode $D_1$ used in the first embodiment. To be specific, the newly employed diode $D_2$ of Fig. 3 functions for balancing with the base-emitter voltage of the transistor comprising the emitter follower 31.

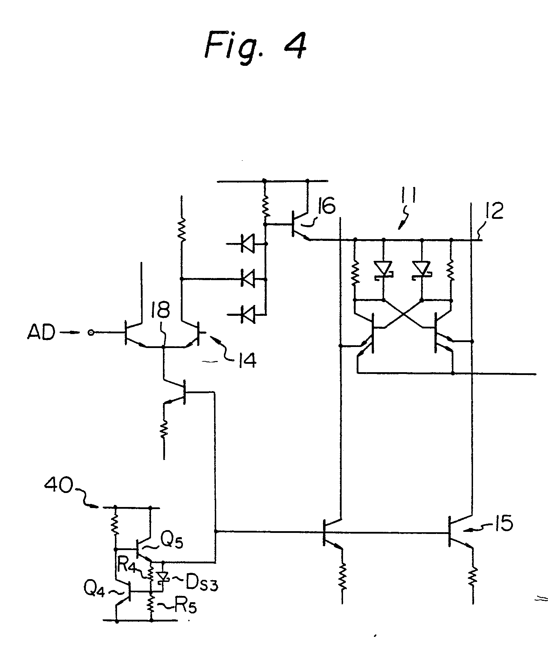

Figure 4 is a circuit diagram of a semiconductor memory device according to a third embodiment of the present invention. In a bias circuit 40 of the third embodiment, the SBD $D_{s3}$ is incorporated in the manner shown in Fig. 4. This arrangement has the following two advantages. First, an optimum load characteristic can be obtained because a feedback path is created from a transistor $Q_5$ to a transistor $Q_4$. Second, the value of the $V_F$ of the SBD $D_{s3}$ can be shifted, in advance, to a desired value by suitably selecting the ratio between the values of resistors $R_4$ and $R_5$.

As mentioned above in detail, the semiconductor memory device can not only achieve high speed read/write operation, but can also finely cope with effects of variation of the forward voltage $V_F$ of Schottky barrier diodes in memory cells of the device.

## Claims

1. A semiconductor memory device comprising:
a plurality of word lines (12);
a plurality of bit lines (13);
static type memory cells (11) connected to the word lines (12) and the bit lines (13) and having as their loads, parallel circuits comprising each a first Schottky barrier diode ($D_{S1}$, $D_{S2}$) and a resistor ($R_1$, $R_2$);
word decoder driver circuits (14, 16, 17, 18, $R_3$), comprising
word line driving means (16) connected to the word lines, operable to determine word line voltage, and
first constant-current circuitry (18) connected to the word line driving means and operable to generate current in dependence upon which such means are operable to determine word line voltage,
second constant-current circuitry (15) operable to generate bit line current, and
a bias circuit (20, 30, 40) for supplying a bias voltage to said first (18) and second (15) constant-current circuitry in common for controlling current generated by the first (18) and second (15) constant-current circuitry;
characterised in that
said bias circuit (20, 30, 40) comprises a second Schottky barrier diode ($D_{S3}$), having a forward voltage substantially the same as that of said first Schottky barrier diodes ($D_{S1}$, $D_{S2}$) and in dependence upon which said bias voltage is determined, whereby word line voltage and bit line current are determined in dependence upon the forward voltage, so that effects of variation of the forward voltage of said first Schottky barrier diodes ($D_{S1}$, $D_{S2}$) upon operations of said memory cells (11) are compensated.

2. A semiconductor memory device as set forth in claim 1, wherein
said bias circuit (20, 30) comprises a first resistor, said second Schottky barrier diode ($D_{S3}$) and a first diode ($D_1$) connected in series;
said bias voltage being determined by the voltage level developed at an intermediate connection between said first resistor and said second Schottky barrier diode ($D_{S3}$);
said first diode ($D_1$) serving for balancing with a base-emitter voltage of a transistor comprised in said second constant-current circuitry (15).

3. A semiconductor memory device as set forth in claim 2, wherein in said bias circuit (30)
an emitter follower transistor (31) is further employed and connected, at its base, to said intermediate connection between said first resistor and said second Schottky barrier diode ($D_{S3}$); and
a second diode ($D_2$) is further employed and is connected with said first diode ($D_1$) in series,
the second diode ($D_2$) serving for balancing with a base-emitter voltage of said emitter follower transistor (31).

4. A semiconductor memory device as set forth in claim 1, wherein
said bias circuit (40) comprises at least first ($Q_5$) and second ($Q_4$) transistors, two resistors ($R_4$, $R_5$) connected in series, and also said second Schottky barrier diode ($D_{S3}$);
one of said resistors ($R_4$) forms a parallel circuit with said second Schottky barrier diode ($D_{S3}$), the parallel circuit forming a feedback path through an emitter of said first transistor ($Q_5$) and a base of said second transistor ($Q_4$), the collector of which is connected to a base of said first transistor ($Q_5$);
the other resistor ($R_5$) is connected between the base and emitter of said second transistor ($Q_4$); and
said bias voltage is developed at the emitter of said first transistor ($Q_5$).

## Revendications

1. Dispositif de mémoire à semiconducteur, comprenant:
plusieurs lignes de mot (12);
plusieurs lignes de bit (13);
des cellules de mémoire du type statique (11) connectées aux lignes de mot (12) et aux lignes de bit (13) et possédant, comme charges, des circuits parallèles constitués chacun d'une première diode à barrière de Schottky ($D_{s1}$, $D_{s2}$) et d'une résistance ($R_1$, $R_2$);
des circuits d'excitation décodeurs de mot (14, 16, 17, 18, $R_3$), comprenant
des moyens d'excitation de lignes de mot (16) connectés aux lignes de mot, ayant pour fonction de déterminer la tension des lignes de mot, et
un premier circuit à courant constant (18) con-

necté aux moyens d'excitation de lignes de mot et ayant pour fonction de produire un courant en fonction duquel ces moyens sont susceptibles de déterminer la tension des lignes de mot,

un deuxième circuit à courant constant (15) ayant pour fonction de produire un courant de lignes de bit, et

un circuit de polarisation (20, 30, 40) servant à délivrer une tension de polarisation auxdits premier circuit (18) et deuxième circuit (15) à courant constant en commun afin de commander le courant produit par les premier circuit (18) et deuxième circuit (15) à courant constant;

caractérisé en ce que

ledit circuit de polarisation (20, 30, 40) comprend une deuxième diode à barrière de Schottky (D$_{s3}$), ayant une tension de sens passant qui est sensiblement identique à celle desdites premières diodes à barrière de Schottky (D$_{s1}$, D$_{s2}$) et en fonction de laquelle ladite tension de polarisation est déterminée, si bien que la tension des lignes de mot et le courant des lignes de bit sont déterminés en fonction de la tension de sens passant, de sorte que les effets dus à la variation de la tension de sens passant desdites premières diodes à barrière de Schottky (D$_{s1}$, D$_{s2}$) sur les opérations desdites cellules de mémoire (11) subissent une compensation.

2. Dispositif de mémoire à semiconducteur selon la revendication 1, où

ledit circuit de polarisation (20, 30) comprend une première résistance, ladite deuxième diode à barrière de Schottky (D$_{s3}$) et une première diode (D$_1$) connectées en série;

ladite tension de polarisation étant déterminée par le niveau de tension créé en une connexion intermédiaire entre ladite première résistance et ladite deuxième diode à barrière de Schottky (D$_{s3}$);

ladite première diode (D$_1$) servant à équilibrer la tension base-émetteur d'un transistor appartenant audit deuxième circuit à courant constant (15).

3. Dispositif de mémoire à semiconducteur selon la revendication 2, où, dans ledit circuit de polarisation (30),

un transistor à charge d'émetteur (31) est employé et connecté, par sa base, à ladite connexion intermédiaire entre ladite première résistance et ladite deuxième diode à barrière de Schottky (D$_{s3}$); et

une deuxième diode (D$_2$) est en outre employée et est connectée avec ladite première diode (D$_1$) en série,

la deuxième diode (D$_2$) servant à équilibrer la tension base-émetteur dudit transistor à charge d'émetteur (31).

4. Dispositif de mémoire à semiconducteur selon la revendication 1, où

ledit circuit de polarisation (40) comprend au moins un premier transistor (Q$_5$) et un deuxième transistor (Q$_4$), deux résistances (R$_4$, R$_5$ connectées en série, et également ladite deuxième diode à barrière de Schottky (D$_{s3}$);

une desdites résistances (R$_4$) forme un circuit

parallèle avec ladite deuxième diode à barrière de Schottky (D$_{s3}$), le circuit parallèle formant un trajet de réaction via l'émetteur dudit premier transistor (Q$_5$) et la base dudit deuxième transistor (Q$_4$), dont le connecteur est connecté à la base dudit premier transistor (Q$_5$);

l'autre résistance (R$_5$) est connectée entre la base et l'émetteur dudit deuxième transistor (Q$_4$); et

ladite tension de polarisation est créée sur l'émetteur dudit premier transistor (Q$_5$).

**Patentansprüche**

1. Halbleiterspeichervorrichtung mit:
einer Vielzahl von Wortleitungen (12);
einer Vielzahl von Bitleitungen (13);
statischen Speicherzellen (11), die mit den Wortleitungen (12) und den Bitleitungen (13) verbunden sind und als ihre Lasten Parallelschaltungen haben, die jeweils eine erste Schottky-Sperrschichtdiode (D$_{S1}$, D$_{S2}$) und einen Widerstand (R$_1$, R$_2$) umfassen;
Wortdecodertreiberschaltungen (14, 16, 17, 18, R$_3$), mit
Wortleitungstreibereinrichtungen (16), die mit den Wortleitungen verbunden sind und zur Bestimmung der Wortleitungsspannung dienen, und
einer ersten Konstantstromschaltung (18), die mit der Wortleitungstreibereinrichtung verbunden ist und zur Erzeugung eines Stromes in Abhängigkeit von solch einer Einrichtung betreibbar ist, um die Wortleitungsspannung zu bestimmen,
einer zweiten Konstantstromschaltung (15), die betreibbar ist, um einen Bitleitungsstrom zu erzeugen, und
einer Vorspannungsschaltung (20, 30, 40) zur gemeinsamen Zuführung einer Vorspannung zu der genannten ersten (18) und zweiten (15) Konstantstromschaltung zur Steuerung des Stromes, der durch die erste (18) und zweite (15) Konstantstromschaltung erzeugt wird; dadurch gekennzeichnet, daß die genannte Vorspannungsschaltung (20, 30, 40) eine zweite Schottky-Sperrschichtdiode (D$_{S3}$) umfaßt, die eine Vorwärtsspannung hat, welche im wesentlichen dieselbe ist wie diejenige der genannten ersten Schottky-Sperrschichtdioden (D$_{S1}$, D$_{S2}$) und in Abhängigkeit von welcher die genannte Vorspannung bestimmt wird, wodurch eine Wortleitungsspannung und ein Bitleitungsstrom in Abhängigkeit von der Vorwärtsspannung bestimmt werden, so daß Effekte der Variation der Vorwartspannung der genannten ersten Schottky-Sperrschichtdiode (D$_{S1}$, D$_{S}$2) auf Betriebe der genannten Speicherzellen (11) kompensiert werden.

2. Halbleiterspeichervorrichtung nach Anspruch 1, bei welcher
die genannte Vorspannungsschaltung (20, 30) einen ersten Widerstand, die genannte zweite Schottky-Sperrschichtdiode (D$_{S3}$) und eine erste Diode (D$_1$), in Reihe geschaltet, umfaßt;

die genannte Vorspannung bestimmt wird durch den Spannungspegel, der an einer Zwischenverbindung zwischen dem genannten ersten Widerstand und der genannten zweiten Schottky-Sperrschichtdiode ($D_{S3}$) entwickelt wird;

die genannte erste Diode ($D_1$) zum Ausgleich mit einer Basisemitterspannung eines Transistors diente, der in der genannten zweiten Konstantstromschaltung (15) enthalten ist.

3. Halbleiterspeichervorrichtung nach Anspruch 2, bei welcher in der genannten Vorspannungsschaltung (30)

ein Emitterfolgetransistor (31) verwendet ist und an seiner Basis mit der genannten Zwischenverbindung zwischen dem genannten ersten Widerstand und der genannten Schottky-Sperrschichtdiode ($D_{S3}$) verbunden ist; und

eine zweite Diode ($D_2$), mit der genannten ersten Diode ($D_1$) in Reihe geschaltet, verwendet ist,

die zweite Diode ($D_2$) zum Ausgleich mit einer Basisemitterspannung des genannten Emitterfolgetransistors (31) dient.

4. Halbleiterspeichervorrichtung nach Anspruch 1, bei welcher

die genannte Vorspannungsschaltung (40) wenigstens erste ($Q_5$) und zweite ($Q_4$) Transistoren, zwei Widerstände ($R_4$, $R_5$), die in Reihe geschaltet sind, und auch die genannte zweite Schottky-Sperrschichtdiode ($D_{S3}$) umfaßt;

einer der Widerstände ($R_4$) eine Parallelschaltung mit der genannten zweiten Schottky-Sperrschichtdiode ($D_{S3}$) bildet, die Parallelschaltung einen Rückkopplungsweg durch einen Emitter des genannten ersten Transistors ($Q_5$) und eine Basis des genannten zweiten Transistors ($Q_4$) bildet, dessen Kollektor mit der Basis des genannten ersten Transistors ($Q_5$) verbunden ist;

der andere Widerstand ($R_5$) zwischen der Basis und dem Emitter des genannten zweiten Transistors ($Q_4$) angeschlossen ist;

und die Vorspannung an dem Emitter des genannten ersten Transistors ($Q_5$) entwickelt wird.

Fig. 1

Fig. 2

0 084 252

2

**0 084 252**

*Fig. 3*

3

0 084 252

# Fig. 4